# EUROPEAN PATENT SPECIFICATION

(11) **EP 0 609 069 B1**
(45) Date of publication and mention of the grant of the patent: **21.04.1999**
(21) Application number: 94300587.6
(22) Date of filing: 27.01.1994
(51) Int. Cl.: H01L 21/00

(54) **Method and apparatus for manufacturing semiconductor devices**
Verfahren und Vorrichtung zur Herstellung von Halbleitervorrichtungen
Procédé et appareil pour fabriquer des dispositifs semi-conducteurs

(30) Priority: 29.01.1993 JP 32442/93
(43) Date of publication of application: 03.08.1994
(73) Proprietor: CANON KABUSHIKI KAISHA, Tokyo (JP)
(72) Inventor: Inoue, Shunsuke, c/o Canon Kabushiki Kaisha, Tokyo (JP); Hoshi, Junichi, c/o Canon Kabushiki Kaisha, Tokyo (JP); Watanabe, Takanori, c/o Canon Kabushiki Kaisha, Tokyo (JP)
(74) Representative: Beresford, Keith Denis Lewis

(56) References cited:
- EP-A- 0 434 434
- EP-A- 0 444 714
- EP-A- 0 462 563
- US-A- 4 473 455
- US-A- 5 105 556
- DATABASE WPI Section EI, Week 8718, Derwent Publications Ltd., London, GB; Class U11, AN 87-128378 & SU-A-1 257 730 (NIKOLAEV) 15 September 1986

## Description

The present invention relates to an etching process, a method of producing a semiconductor device and an apparatus.

Various etching processes and apparatus have been adopted for manufacturing semiconductor devices.

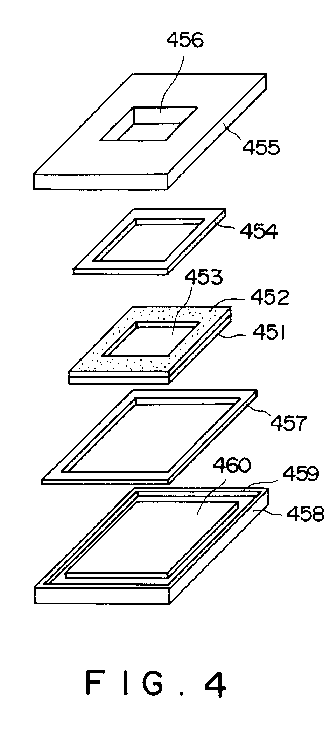

For example, when a pressure sensor or cantilever is fabricated on a silicon chip by micromachining, a jig is used as shown in Fig. 4 for anisotropic etching by immersion in an alkaline etching solution such as a KOH aqueous solution.

In Fig. 4, 451 is an Si chip to be etched, 452 is an anti-etching mask, and 453 is a portion that is to be etched. The chip 451 is laid on a sample carrier 460 of a jig lower lid 458.

Then, an O-ring gasket seal 454 is placed on the upper face of sample 451, and then a jig upper lid 455, having a groove for the gasket 454, is placed thereon. The jig upper lid 455 has a window 456 by which the etching solution enters, the window having dimensions smaller than the gasket 454, and slightly larger than the pattern 453. Also, the upper lid 455 and the lower lid 458 are sealed by another gasket 457.

By using such a jig, the etching solution immersing the chip 451 has direct contact with the sample 451 only in the neighbourhood of a desired pattern for the etching. Accordingly, even if there is any Al wiring to be immersed in the etching solution on the back face side (sample carrier side) of the sample 451, for example, it is never corroded by the etching solution.

However, in the above arrangement a margin portion of the chip 451 is required, outside of the pattern 453 desired to be etched, for accommodating the gasket 454.

For example, when an Si chip with a formed semiconductor integrated circuit is subjected to etching as aforesaid, the increased chip area due to the margin portion reduces the number of chips that can be obtained by dicing a wafer of standard size, directly increasing the chip production cost.

Further, an additional time for incorporating the chip into the jig is necessary, and the gasket 454 and the chip 451 must be placed in correct alignment. When this is done manually without the use of any especially precise apparatus, the precision of alignment is not very good, so that a further excess portion for accommodating such an alignment error also is required.

An object of the present invention is to provide an etching process for manufacturing a semiconductor device that can be performed without requiring a substantive margin chip area.

It is another object of the present invention to provide an etching process, for manufacturing a semiconductor device, that can be performed cleanly without introducing substantive contamination, with a higher efficiency and a higher productivity than heretofore.

In the present invention, as defined by claims 1, 7 and 8 appended hereto, because of supplying an etching agent to the chip while forcing a gas introduced into a closed space formed by clamp means from the clearance between said chip and said clamp means, no etching agent will arrive at the inner-facing one principal face of the chip, whereby the inner-facing principal face of the semiconductor chip is not etched. Therefore, considering an instance where an integrated circuit is formed on this one face of the chip, clean etching can be performed without causing any contamination of, or damage to the integrated circuit, as will be easily understood.

Etching, for example, may be performed by supplying an etching solution in a stream, shower or spray.

A closure member for closing the space formed using the clamp means may be provided integrally with, or separately from, the remainder of the clamp means. The gas introduced into the closed space may be selected appropriately from inert gases such as air, clean air, nitrogen, as well as He, Ar, and Ne, for example.

In the etching applied to the semiconductor chip, there is no need for the same margin area as conventionally required, resulting in effective smaller chip area, whereby it is possible to provide more chips per wafer, and thus more cheaply.

Also, because this etching process has an enhanced operating efficiency and productivity in etching and can be effected cleanly without causing contamination, reliability of the chips can be enhanced.

Also, this etching process has excellent controllability.

The etching process defined by the claims includes introducing a gas into a closed space behind the etch sample. In this context it is mentioned that EP-A-0462563 discloses an etching process applied to a semiconductor wafer and, apparatus therefor, in which an annular margin area of one face of the wafer is engaged with a clamp ring while an annular margin area on the other face of the wafer is engaged with the rim of a supporting body. A closed space is provided between the wafer and the supporting body and gas is introduced into this closed space to effect heat exchange during etching. The heat exchange is controlled by regulating the pressure of the gas in the closed space, which pressure otherwise might fall due to gas leakage at the rim.

It has also been known to use a gas seal to prevent etchant reaching the reverse side of a sample body. In EP-A-0444714, and US-A-4903717 equivalent thereto, a wafer etching process and apparatus are described in which the wafer is suspended, above a supporting body, on a cushion of air. In the arrangement described, gas is expelled from an annular orifice at the periphery of the wafer. The wafer is held in place under its own weight and by virtue of a pressure differential between the ambient air pressure and a reduced air pressure beneath the wafer caused by the Bernoulli effect of the expelled gas. Stops, on the rim of the supporting body, are used to limit lateral displacement of the wafer.

Preferred embodiments of the present invention will now be described by way of example and with reference to the accompanying drawings of which:

Fig. 1 is a typical view for explaining an etching process in the present invention.

Fig. 2 is a typical view for explaining a clamp state in holding means of the present invention.

Fig. 3 is a typical view for explaining a clamp state in holding means of the present invention.

Fig. 4 is a typical view for explaining a conventional etching process.

### [Example 1]

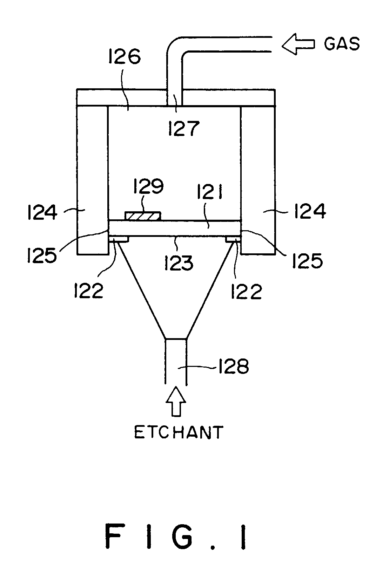

Referring to Fig. 1, one example of the present invention will be described below.

In Fig. 1, 121 is an Si chip, that is to be etched, having a thickness of 625µm, and a size of about 15mm x 12mm. 122 is an SiO₂ film which is an etching mask, having a thickness of approximately 1µm. 123 is the portion to be etched, which is located approximately 1mm apart from the chip edge 125 and has a size of 13mm x 10mm. The chip edge 125 is clamped from four sides thereof by a clamp 124. The edge 125 is cut out substantially vertically from an Si wafer, normally with a precision of approximately ± 10µm, and thus has a very excellent shape. Hence, the clearance between the edge 125 and the clamp 124 is very small except for the corner portions of the chip.

Then, an inert gas such as air or nitrogen is introduced through a nozzle 127 into a substantially sealed space 126 formed by the clamp 124 at a pressure slightly higher than the external pressure (atmospheric pressure). The pressure must not be so high as to destroy the clamping of the chip, as described above. Introduced gas is blasted through the clearance between the edge 125 and the clamp 124.

Then, a KOH aqueous solution as the etchant is directed from below through a nozzle 128. The solution impinges on the lower surface of the member 121 in a stream, shower or spray-like manner, but no solution arrives at the upper face of the member and the edges 125 due to the gas being blasted. Therefore, an integrated circuit 129, which is provided on the upper face of the chip 121 immersed in etching solution, is not exposed to the solution. This example is an open system in which the chip is clamped by the clamp, easily allowing for automation. The chip is easily clamped and removed without requiring any excess time. Also, there is no extra expense of the gasket up to 4mm, as was the case with a jig of the conventional example, the distance between the etching pattern 123 and the edge being only 1mm or less.

Also, owing to the pressure of the inert atmosphere, corrosive mist and gas are prevented from rising from the etchant.

Also, the etching process can be easily modified by changing the injection nozzle 128 so that the etchant can be directed as a stream, shower or spray.

Also, rinsing or drying can be readily performed by ejecting either pure water or gas from the nozzle, respectively.

Unlike the conventional jig, both principal planes critical for the chip are not touched in any case, so that no contamination of the chip is introduced. Also, since the etchant is directed from below, any excess etchant will rapidly fall off the chip and the clamp, so that the etchant never remains long in their vicinity to immerse the chip unnecessarily.

Also, by ejecting the etchant from the nozzle at an arbitrary angle, the etching can be progressed in any direction.

By stopping the ejection of the etching solution and instead immediately applying the rinsing solution, an accurate etching termination can be attained.

In another example of the present invention, instead of a KOH aqueous solution for the etchant, other alkaline anisotropic etchants can be employed, for example, ethylene diamine, pyrocatechol, aqueous mixtures thereof, or TMAH (tetramethyl ammonium hydroxide) aqueous solution.

### [Example 2]

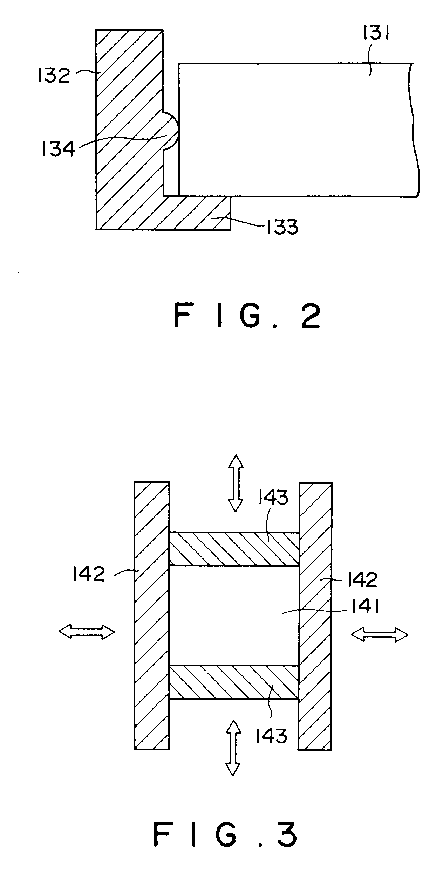

One or more claws 133 or projections 134, or both may be provided to retain the chip 131 in the clamp 132, as shown in Fig. 2.

### [Example 3]

To be able to clamp chips of different sizes, adjustable clamps 142, 143 constituted as shown in Fig. 3, can be adopted. Fig. 3 is a plan view from above showing an arrangement where the four side walls of a semiconductor chip 141 are engaged by two pairs of clamp jaws 142, 143. As shown in the figure, an inner pair of clamp jaws 143 is movable inside an outer pair of clamp jaws 142, thereby accommodating different sizes of the chip 141.

### [Example 4]

Not only by pressurizing the gas to be introduced but also reducing the pressure of the atmosphere, the equivalent difference in pressure can be attained.

With such a constitution, any mist and gas arising from the area in direct contact with the etching solution residing below can be safely exhausted.

## Claims

1. An etching process, applied to a semiconductor chip, comprising the following steps of:
holding the semiconductor chip (121; 131; 141) in clamp means (124; 132-134; 142; 143) by engaging the side surfaces of said clamp means with the edge walls (125) of said chip in close contact but for a small clearance space through which gas can flow, said clamp means forming, with the inner-facing principal face of the chip, a closed space (126);
introducing a gas into said closed space; and
supplying an etching solution to the outer-facing principal face of the chip thereby etching the outer-facing principal face of the chip while said gas is forced to flow from said closed space outwards towards the outer-facing principal face of the chip through said clearance space between the edge walls of the chip and said side surfaces of said clamp means.

2. A process according to claim 1, wherein said supplying is performed by directing the etching solution in a stream, shower or spray onto the outer-facing principal face of the chip.

3. A process according to either of claims 1 or 2, applied to a silicon chip.

4. A process according to any preceding claim, wherein:
said etching is conducted at atmospheric pressure; and
the pressure of said gas in said closed space is higher than atmospheric pressure.

5. A process according to any preceding claim wherein said gas is one of air, clean air, nitrogen, helium, argon or neon.

6. A process according to any preceding claim wherein said etching is performed using an injection nozzle to direct etching solution onto the outer-facing principal face of the chip, and
either or both of a rinsing operation and a drying operation, respectively are performed using said injection nozzle to direct rinsing solution or drying gas, respectively, onto the outer-facing principal face of the chip.

7. A method of producing a semiconductor device comprising steps of:
producing a semiconductor device structure (129) on a principal face of a semiconductor chip (121); and
applying the etching process of any preceding claim to said semiconductor chip using the structure bearing principal face thereof as the inner-facing principal face of the semiconductor chip in said etching process.

8. An apparatus for performing the etching process of claim 1, said apparatus comprising:
clamp means (124; 132-134; 142; 143), to engage the edge walls (125) of a semiconductor chip (121; 131; 141) in close contact but for a small clearance space allowing flow of gas, said clamp means being adapted to form a closed space (126) with a principal face of the semiconductor chip;
gas inlet means (127) to introduce gas into the closed space formed by said clamp means;
pressure differential means for maintaining gas in said closed space at higher pressure than the pressure outside said closed space during etching, so that the gas shall be forced from said closed space, outwards towards the outer-facing principal face of the chip, through the clearance space; and
etchant supply means (128), arranged facing said clamp means, to supply an etchant to the outer-facing principal face of the semiconductor chip when the same is held in place by said clamp means.

9. An apparatus according to claim 8 wherein said clamp means (132-134) has projections (134) to engage the edge walls of the semiconductor chip (131).

10. An apparatus according to either of claims 8 and 9 wherein said clamp means (132-134) has claws (133) to act as stops to retain the semiconductor chip (131) engaged by said clamp means.

11. An apparatus according to claim 8 wherein said clamp means (142, 143) comprises two mutually perpendicular pairs of jaws (142, 143) one pair (143) thereof being arranged within, and adjustable relative, to the other pair (142), to accommodate semiconductor chips (141) of different sizes.

## Patentansprüche

1. Ätzprozeß, der bei einem Halbleiterchip angewendet wird, mit den folgenden Schritten:
Halten des Halbleiterchips (121; 131; 141) in einer Klemmeinrichtung (124; 132 - 134; 142;143) durch einen Eingriff der Seitenflächen der Klemmeinrichtung mit den Randwänden (125) des Chips in einem engen Kontakt, wobei jedoch für einen kleinen Zwischenraum Platz belassen ist, durch den ein Gas strömen kann, wobei die Klemmeinrichtung mit der nach innen weisenden Hauptseite des Chips einen geschlossenen Raum (126) ausbildet,
Einleiten eines Gases in den geschlossenen Raum und
Zuführen einer Ätzlösung zu der nach außen weisenden Hauptseite des Chips, wodurch die nach außen weisende Hauptseite des Chips geätzt wird, während das Gas dazu gedrängt wird, daß es von dem geschlossenen Raum nach außen zu der nach außen weisenden Hauptseite des Chips durch den Zwischenraum zwischen den Randwänden des Chips und der Seitenflächen der Klemmeinrichtung strömt.

2. Prozeß gemäß Anspruch 1, wobei
das Zuführen durch ein Richten der Ätzlösung in der Form eines Strahles, einer Berieselung oder eines Sprühnebels auf die nach außen weisende Hauptseite des Chips ausgeführt wird.

3. Prozeß gemäß einem der Ansprüche 1 oder 2, der auf einen Siliziumchip angewendet wird.

4. Prozeß gemäß einem der vorherigen Ansprüche, wobei
das Ätzen bei Umgebungsdruck ausgeführt wird und
der Druck des Gases in dem geschlossenen Raum höher als der Umgebungsdruck ist.

5. Prozeß gemäß einem der vorherigen Ansprüche, wobei
das Gas entweder Luft, Reinluft, Stickstoff, Helium, Argon oder Neon ist.

6. Prozeß gemäß einem der vorherigen Ansprüche, wobei
das Ätzen unter Verwendung einer Einspritzdüse zum Richten der Ätzlösung auf die nach außen weisende Hauptseite des Chips ausgeführt wird und
entweder ein Auswaschvorgang oder ein Trocknungsvorgang oder beide jeweils unter Verwendung der Einspritzdüse zum Richten der Auswaschlösung oder des Trocknungsgases jeweils auf die nach außen weisende Hauptseite des Chips ausgeführt werden.

7. Verfahren zum Erzeugen einer Halbleitervorrichtung mit den folgenden Schritten:
Erzeugen eines Halbleitervorrichtungsaufbaus (129) auf einer Hauptseite eines Halbleiterchips (121) und
Anwenden des Ätzprozesses gemäß einem der vorherigen Ansprüche auf den Halbleiterchip unter Verwendung des Aufbaus, der dessen Hauptseite als die nach innen weisende Hauptseite des Halbleiterchips bei diesem Ätzprozeß trägt.

8. Gerät zum Ausführen des Ätzprozesses gemäß Anspruch 1, wobei dieses Gerät folgendes aufweist:
eine Klemmeinrichtung (124; 132 - 134; 142; 143), um mit den Randwänden (125) eines Halbleiterchips (121; 131; 141) in einem engen Kontakt in Eingriff zu gelangen, wobei jedoch ein kleiner Zwischenraum eine Gasströmung ermöglicht, wobei die Klemmeinrichtung daran angepaßt ist, daß sie einen geschlossenen Raum (126) mit einer Hauptseite des Halbleiterchips ausbildet,
eine Gaseinlaßeinrichtung (127) zum Einleiten eines Gases in den geschlossenen Raum, der durch die Klemmeinrichtung ausgebildet ist,
eine Druckdifferenziereinrichtung zum Halten eines Gases in dem geschlossen Raum bei einem höheren Druck als der Druck außerhalb des geschlossenen Raumes während des Ätzens, so daß das Gas von dem geschlossenen Raum nach außen zu der nach außen weisenden Hauptseite des Chips durch den Zwischenraum gedrängt wird, und
eine Ätzmittelzuführeinrichtung (128), die so eingerichtet ist, daß sie der Klemmeinrichtung zugewandt ist, um ein Ätzmittel zu der nach außen weisenden Hauptseite des Halbleiterchips zu liefern, wenn selbiger an Ort und Stelle durch die Klemmeinrichtung gehalten wird.

9. Gerät gemäß Anspruch 8, wobei
die Klemmeinrichtung (132-134) Vorsprünge (134) hat, um mit den Randwänden des Halbleiterchips (131) in Eingriff zu gelangen.

10. Gerät gemäß Anspruch 8 oder 9, wobei
die Klemmeinrichtung (132 - 134) Klauen (133) hat, um als Ablage zum Halten des mit der Klemmeinrichtung in Eingriff stehenden Halbleiterchips (131) zu wirken.

11. Gerät gemäß Anspruch 8, wobei
die Klemmeinrichtung (142, 143) zwei zueinander senkrechte Paare an Klemmbacken (142, 143) aufweist, wobei ein Paar (143) davon innerhalb des anderen Paares (142) und relativ zu diesem einstellbar angeordnet ist, um Halbleiterchips (141) mit unterschiedlichen Größen unterzubringen.

## Revendications

1. Procédé d'attaque chimique, appliqué à une puce de semiconducteurs, comprenant les étapes suivantes dans lesquelles :
on maintient la puce de semiconducteurs (121 ; 131 ; 141) dans des moyens de serrage (124 ; 132-134 ; 142 ; 143) en engageant les surfaces latérales desdits moyens de serrage avec les parois (125) des bords de ladite puce en contact étroit, sauf dans un petit espace de dégagement à travers lequel un gaz peut s'écouler, lesdits moyens de serrage formant, avec la face principale tournée vers l'intérieur de la puce, un espace fermé (126) ;
on introduit un gaz dans ledit espace fermé ; et
on applique une solution d'attaque chimique à la face principale, tournée vers l'extérieur, de la puce, attaquant ainsi chimiquement la face principale tournée vers l'extérieur de la puce, tandis que ledit gaz est mis en écoulement forcé depuis ledit espace fermé vers l'extérieur en direction de la face principale tournée vers l'extérieur de la puce, à travers ledit espace de dégagement entre les parois des bords de la puce et lesdites surfaces latérales desdits moyens de serrage.

2. Procédé selon la revendication 1, dans lequel on effectue ladite application en dirigeant la solution d'attaque chimique, formant un courant, une aspersion ou une pulvérisation, sur la face principale tournée vers l'extérieur de la puce.

3. Procédé selon l'une des revendications 1 ou 2, appliqué à une puce de silicium.

4. Procédé selon l'une quelconque des revendications précédentes, dans lequel :
ladite attaque chimique est effectuée à la pression atmosphérique ; et
la pression dudit gaz dans ledit espace fermé est plus élevée que la pression atmosphérique.

5. Procédé selon l'une quelconque des revendications précédentes, dans lequel ledit gaz est l'un de l'air, de l'air épuré, de l'azote, de l'hélium, de l'argon ou du néon.

6. Procédé selon l'une quelconque des revendications précédentes, dans lequel ladite attaque chimique est effectuée par utilisation d'une buse d'injection pour diriger une solution d'attaque chimique sur la face principale, tournée vers l'extérieur, de la puce, et
l'une d'une opération de rinçage et d'une opération de séchage, ou les deux, respectivement, sont effectuées en utilisant ladite buse d'injection pour diriger une solution de rinçage ou un gaz de séchage, respectivement, sur la face principale, tournée vers l'extérieur, de la puce.

7. Procédé de production d'un dispositif semiconducteur, comprenant les étapes dans lesquelles :
on produit une structure (129) de dispositif semiconducteur sur une face principale d'une puce semiconductrice (121) ; et
on applique le procédé d'attaque chimique de l'une quelconque des revendications précédentes à ladite puce semiconductrice en utilisant sa face principale portant une structure en tant que face principale, tournée vers l'intérieur, de la puce semiconductrice dans ledit procédé d'attaque chimique.

8. Appareil pour exécuter le procédé d'attaque chimique de la revendication 1, ledit appareil comportant :
des moyens de serrage (124 ; 132-134 ; 142 ; 143) destinés à engager les parois (125) des bords d'une puce semiconductrice (121 ; 131; 141) en contact étroit, sauf dans un petit espace de dégagement permettant l'écoulement d'un gaz, lesdits moyens de serrage étant conçus pour former un espace fermé (126) avec une face principale de la puce semiconductrice ;
des moyens (127) d'entrée de gaz pour introduire un gaz dans l'espace fermé formé par lesdits moyens de serrage ;
des moyens à pression différentielle destinés à maintenir le gaz se trouvant dans ledit espace fermé sous une pression plus élevée que la pression à l'extérieur dudit espace fermé pendant l'attaque chimique, afin que le gaz soit déplacé à force depuis ledit espace fermé, vers l'extérieur et en direction de la face principale, tournée vers l'extérieur, de la puce, à travers l'espace de dégagement ; et
des moyens (128) d'application d'un agent d'attaque chimique, agencés de façon à faire face auxdits moyens de serrage, pour appliquer un agent d'attaque chimique à la face principale, tournée vers l'extérieur, de la puce semiconductrice lorsque celle-ci est maintenue en place par lesdits moyens de serrage.

9. Appareil selon la revendication 8, dans lequel lesdits moyens de serrage (132-134) comportent des saillies (134) destinées à engager les parois des bords de la puce semiconductrice (131).

10. Appareil selon l'une des revendications 8 et 9, dans lequel lesdits moyens de serrage (132-134) comportent des griffes (133) destinées à agir en tant que butées pour retenir la puce semiconductrice (131) engagée par lesdits moyens de serrage.

11. Appareil selon la revendication 8, dans lequel lesdits moyens de serrage (142, 143) comprennent deux paires mutuellement perpendiculaires de mors (142, 143) dont une paire (143) est agencée à l'intérieur de, et réglable par rapport à, l'autre paire (142), pour recevoir des puces semiconductrices (141) de différentes dimensions.
